Europäisches Patentamt

European Patent Office

Office européen des brevets

(19)

(11) Veröffentlichungsnummer: **0 277 501**
**A2**

(12) # EUROPÄISCHE PATENTANMELDUNG

(21) Anmeldenummer: **88100375.0**

(22) Anmeldetag: **13.01.88**

(51) Int. Cl.⁴: **H03H 7/48**

(30) Priorität: **31.01.87 DE 3702896**

(43) Veröffentlichungstag der Anmeldung:
**10.08.88 Patentblatt 88/32**

(84) Benannte Vertragsstaaten:
**DE FR IT**

(71) Anmelder: **Licentia Patent-Verwaltungs-GmbH**
**Theodor-Stern-Kai 1**
**D-6000 Frankfurt/Main 70(DE)**

(72) Erfinder: **Szpilok, Waldemar, Dipl.-Ing.**
**Hubertusstrasse 8b**
**D-4100 Duisburg 74(DE)**

(74) Vertreter: **Amersbach, Werner, Dipl.-Ing. et al**
**Licentia Patent-Verwaltungs-GmbH**
**Theodor-Stern-Kai 1**
**D-6000 Frankfurt 70(DE)**

(54) **Brückenschaltung mit Lastausgleichswiderständen.**

(57) Die Erfindung betrifft eine Brückenschaltung mit Lastausgleichswiderständen (13, 23, 33) zum rückwirkungsarmen Parallelschalten mehrerer Ein- oder Ausgänge (19, 29, 39). Die Brücke besteht aus mehreren, einseitig (9) parallelgeschalteten und bei etwa der Mittenfrequenz 1/4-langen Leitungen (10, 20, 30), die durch Schwingkreise (11, 12; 21, 22; 31, 32; 97, 98) kompensiert werden. Die Lastausgleichswiderstände (13, 23, 33) zur Entkopplung der Ein- oder Ausgänge (19, 29, 39) sind komplex und einseitig an Masse angeschlossen.

FIG. 3

EP 0 277 501 A2

## Brückenschaltung mit Lastausgleichswiderständen

Die Erfindung bezieht sich auf eine Brückenschaltung mit Lastausgleichswiderständen gemäß dem Oberbegriff des Anspruchs 1. Eine solche Brückenschaltung ist wahlweise als Leistungsaddierer, der mehrere gleiche oder verschiedene Teilleistungen zu einer Summenleistung addiert, oder umgekehrt als Leistungsteiler verwendbar, der eine Summenleistung in mehrere gleiche oder verschiedene Teilleistungen aufteilt.

Brückenschaltungen dieser Art werden beispielsweise in der Sendertechnik eingesetzt. So können z. B. mehrere Sender mit einer solchen Brücke parallelgeschaltet werden, um die Sendeleistung insgesamt zu erhöhen oder um eine "aktive Reserve" bilden zu können, die bei Ausfall eines oder mehrerer Sender die Fortführung des Sendebetriebs mit entsprechend verringerter Leistung gestattet. Mit einer solchen Brücke kann aber auch die von einem Sender kommende Leistung auf mehrere Verbraucher verteilt werden.

Beispiele bekannter Brückenschaltungen, wie die nach Schering oder Maxwell-Wien bzw. der 3 dB-Koppler aus zwei bei der Mittenfrequenz 1/4-langen Leitungen usw., sind im Taschenbuch der Hochfrequenztechnik (Springer-Verlag, Berlin, 1968, 3. Auflage) auf den Seiten 1441 bis 1451 beschrieben. Bei diesen Bréckenschaltungen werden beim Betrieb als Leistungsaddierer bzw. Leistungsteiler die Eingänge bzw. die Ausgänge mit Hilfe von ohmschen Lastausgleichswiderständen entkoppelt, die symmetrisch oder asymmetrisch an die Eingänge bzw. Ausgänge einer solchen Brückenschaltung angeschlossen sind. Damit ist in der Theorie ein rückwirkungsfreier, in der Praxis ein rückwirkungsarmer Betrieb mit einem in der Regel tolerierbaren Rückwirkungsgrad bei der Mittenfrequenz und gleichen Teilleistungen möglich. Weichen jedoch die Frequenzen von der Mittenfrequenz ab und/oder treten verschieden hohe Teilleistungen auf, treten unerwünschte und häufig nicht mehr tolerierbare Rückwirkungen auf, die im allgemeinen um so größer sind, je mehr die Frequenzen von der Mittenfrequenz abweischen bzw. je unterschiedlicher die Teilleistungen in ihrer Höhe sind.

Der Erfindung liegt daher die Aufgabe zugrunde, eine Brückenschaltung zu schaffen, die beim Betrieb als Leistungsaddierer bzw. Leistungsteiler in einem möglichst großen Frequenzbereich (der z. B. eine Oktave umfassen kann) und/oder bei verschieden hohen Teilleistungen (u. a. auch bei Ausfall eines oder mehrerer der angeschlossenen Signalkanäle) eine möglichst hohe gegenseitige Entkopplung der Eingänge bzw. Ausgänge aufweist, so daß ein möglichst rückwirkungsarmer Betrieb mit einem tolerierbaren Rückwirkungsgrad unter den angegebenen Bedingungen möglich ist.

Die erfingungsgemäße Lösung der Aufgabe besteht darin, zur Kompensation der mindestens zwei bei etwa der Mittenfrequenz 1/4-langen Leitungen der Brückenschaltung gemäß dem Oberbegriff des Anspruchs 1 am Summationspunkt der Brückenschaltung einen Reihenschwingkreis in Reihe zu schalten, dessen Resonanzfrequenz etwa mit der Mittenfrequenz übereinstimmt, und an die Ein- bzw. Augänge der Brückenschaltung jeweils einen Parallelschwingkreis anzuschließen, dessen Resonanzfrequenz ebenfalls etwa mit der Mittenfrequenz übereinstimmt und der einseitig an Masse angeschlossen ist, sowie zur Entkopplung der Ein- bzw. Ausgänge die Lastausgleichswiderstände komplex auszuführen und ebenfalls einseitig an Masse anzuschließen.

Die Vorteile der erfindungsgemäßen Lösung bestehen im wesentlichen darin, daß zum einen durch die Kompensationsschaltungen die Transformationseigenschaften der mindestens zwei bei etwa der Mittenfrequenz 1/4-langen Leitungen der Brückenschaltung insbesondere für Frequenzen verbessert werden, die von der Mittenfrequenz abweichen, und zum anderen durch den komplexen Lastausgleichswiderstand eine hohe gegenseitige Entkopplung der Ein-bzw. Ausgänge der Brückenschaltung erzielt wird.

Im folgenden soll die Erfindung anhand einiger ausgewählter Ausführungsbeispiele näher erläutert werden. Es zeigen:

FIG. 1 eine erfindungsgemäße Ausführungsform einer Zweierbrücke;

FIG. 2 eine erfindungsgemäße Ausgestaltung des komplexen Lastausgleichswiderstands für eine Zweierbrücke gemäß FIG. 1;

FIG. 3 eine erfindungsgemäße Ausführungsform einer Dreierbrücke;

FIG. 4 eine erfindungsgemäße Ausgestaltung des komplexen Lastausgleichswiderstands für eine Dreierbrücke gemäß FIG. 3.

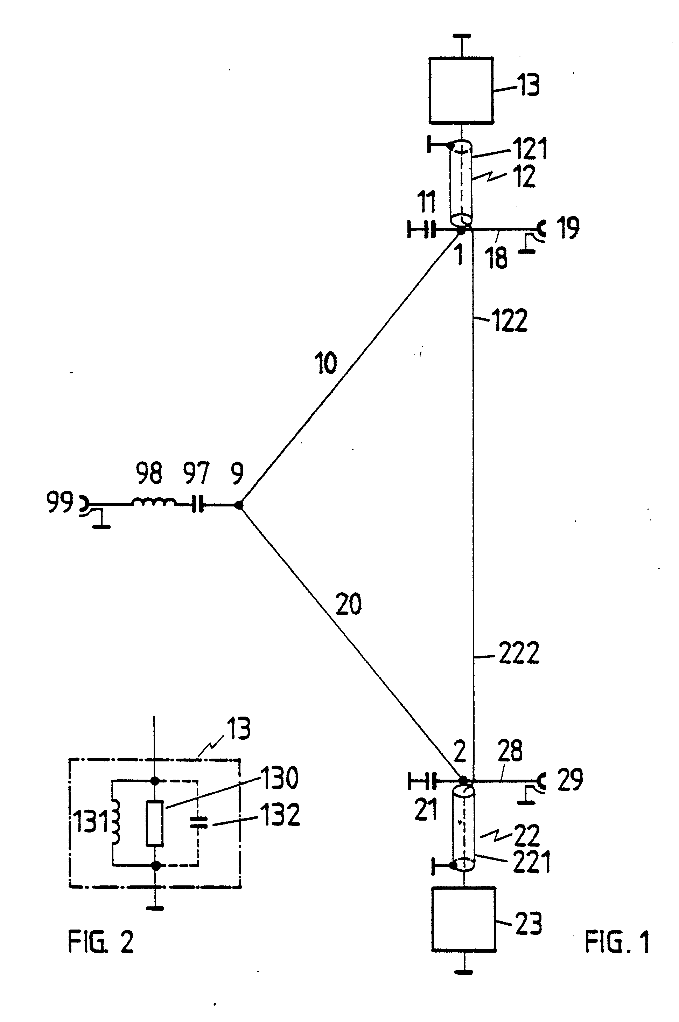

Die erfindungsgemäße Ausführungsform der Zweierbrücke in FIG. 1 besteht aus zwei bei etwa der Mittenfrequenz 1/4-langen Streifenleitungen (10, 20), deren eine Enden in einem Summationspunkt (9) parallelgeschaltet sind und deren andere Enden voneinander getrennt jeweils an einen Verbindungspunkt (1, 2) angeschlossen sind, an den auch jeweils einer der beiden parallelzuschaltenden Ein-oder Ausgänge (19, 29) über je eine Streifenleitung (18, 28) mit dem hochliegenden Pol angeschlossen ist, während der andere Pol an Masse liegt.

Zwischen dem Summationspunkt (9) und dem hochliegenden Pol des Summationsein-oder -ausgangs (99) ist zur Kompensation der Streifenleitungen (10, 20) ein Reihenschwingkreis (97, 98) angeordnet, dessen Resonanzfrequenz mit der Mittenfrequenz der Brückenschaltung in etwa übereinstimmt.

Eine weitere Kompensation der Streifenleitungen (10, 20) wird dadurch erreicht, daß an beiden Verbindungspunkten (1, 2) je ein Parallelschwingkreis angeschlossen ist, der einseitig mit Masse verbunden ist und der aus einem Kondensator (11, 21 und der Induktivität einer koaxialen Leitung (12, 22) besteht, deren Außenleiter (121, 221) mit dem einen Ende an dem jeweiligen Verbindungspunkt (1, 2) und mit dem anderen Ende an Masse angeschlossen ist. Die Länge der koaxialen Leitung ist in Abhängigkeit von der Kapazität des jeweiligen Kondensators so bemessen, daß die Resonanzfrequenz des Parallelschwingkreises in etwa mit der Mittenfrequenz der Brückenschaltung übereinstimmt.

Die Innenleiter (122, 22) der beiden koaxialen Leitungen (12, 22) sind auf der den Verbindungspunkten zugewandten Seite der koaxialen Leitungen untereinander verbunden und auf der von den Verbindungspunkten abgewandten Seite der koaxialen Leitungen jeweils an den hochliegenden Anschluß eines komplexen Lastausgleichswiderstands (13, 23) angeschlossen, dessen anderer Anschluß mit Masse verbunden ist. Die Lastausgleichswiderstände (13, 23) werden über die koaxialen Leitungen (12, 22) in die Brücke eingekoppelt und dienen dazu, die Ein-oder Ausgänge (19, 29) der Brücke zu entkoppeln.

Die in FIG. 2 gezeigte erfindungsgemäße Ausgestaltungsform des komplexen Lastausgleichswiderstandes (13) für die Zweierbrücke in FIG. 1 besteht aus einer Parallelschaltung aus Induktivität (131) und ohmschem Widerstand (130), der zusätzlich ein Kondensator (132) parallelgeschaltet werden kann. Der Lastausgleichswiderstand (23) der erfindungsgemäßen Zweierbrücke in FIG. 1 stimmt in seinem Aufbau mit dem in FIG. 2 gezeigten überein.

Bei einem Labormuster des in den FIG. 1 und 2 gezeigten Beispiels betrugen die Wellenwiderstände an den Ein-oder Ausgängen (19, 29) 50 Ω und wurden durch die Streifenleitungen (10, 20) auf 100 Ω herauftransformiert, wobei die Streifenleitungen (10, 20) selbst einen Wellenwiderstand von 70, 7 Ω besaßen. Am Summationsein-oder -ausgang (99) betrug der Wellenwiderstand 50 Ω.

Mit einer Kapazität von 16 pF und einer Induktivität von 4 nH im Reihenschwingkreis (97, 98), einer Kapazität von jeweils 1.5 pF in den beiden Parallelschwingkreisen (11, 12; 21, 22), einem ohmschen Widerstand (130, 230) von je 75 Ω in den beiden Lastausgleichswiderständen (13, 23) und empirisch angepaßten Werten für die Länge der koaxialen Leitungen (12, 22) und für die Induktivität (131, 231) im komplexen Lastausgleichswiderstand wurde für dieses Labormuster im Frequenzbereicht von etwa 450 MHz bis 900 MHz eine Entkopplung der parallelgeschalteten Ein-oder Ausgänge (19, 29) größer 20 dB erzielt.

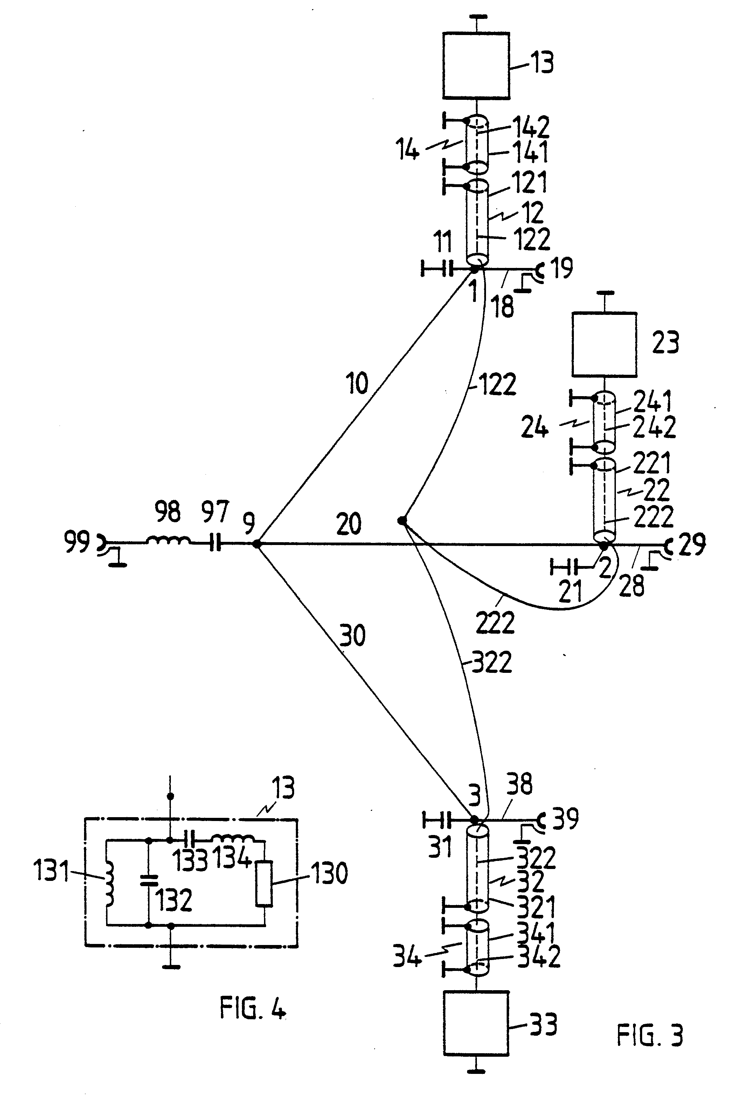

Bei der in FIG. 3 gezeigten erfindungsgemäßen Ausführungsform einer Dreierbrücke wurden die einzelnen Teile nach dem gleichen Schema numeriert wie bei der Zweierbrücke in FIG. 1. Im Vergleich zu FIG. 1 ist in FIG. 3 ein weiterer Brückenzweig hinzugekommen, der aus einer bei etwa der Mittenfrequenz 1/4-langen Streifenleitung (30), einem Verbindungspunkt (3), einer Streifenleitung (38), einem Ein-oder Ausgang (39), einem Parallelschwingkreis (31, 32) und einem komplexen Lastausgleichswiderstand (33) besteht. Der Innenleiter (322) der koaxialen Leitung (32) des dritten Brückenzweiges ist auf der dem Verbindungspunkt (3) zugewandten Seite der koaxialen Leitung (32) mit den entsprechenden Enden der anderen beiden Innenleiter (122, 222) verbunden.

Zusätzlich ist zur richtigen Transformation der komplexen Lastausgleichswiderstände (13, 23, 33) an die Brückenschaltung jeweils zwischen de koaxialen Leitung (12, 22, 32) und dem Lastausgleichswiderstand eine weitere koaxiale Leitung (14, 24, 34) eingefügt, deren Außenleiter (141, 241, 341) an beiden Enden mit Masse verbunden ist, und deren Innenleiter (142, 242, 342) mit dem einen Ende an den Innenleiter (122, 222, 322) der jeweiligen koaxialen Leitung und mit dem anderen Ende an den hochliegenden Anschluß des jeweiligen Lastausgleichswiderstandes (13, 23, 33) verbunden ist.

Die in FIG. 4 gezeigte erfindungsgemäße Ausgestaltungsform des komplexen Lastausgleichswiderstands (13) für die Dreierbrücke in FIG. 3 besteht aus einer Parallelschaltung aus Induktivität (131), Kondensator (132) und einer Reihenschaltung, bestehend aus einer weiteren Induktivität (133), einem weiteren Kondensator (134) und einem ohmschen Widerstand (130). Die Lastausgleichswiderstände (23, 33) der erfindungsgemäßen Dreierbrücke in FIG. 3 stimmen in ihrem Aufbau mit dem in FIG. 4 gezeigten überein.

Bei einem Labormuster des in den FIG. 3 und 4 gezeigten Beispiels betrugen die Wellenwiderstände an den Ein-oder Ausgängen (19, 29, 39) 50 Ω und wurden durch die Streifenleitungen (10, 20, 30) auf 150 Ω herauftransformiert, wobei die Streifenleitungen (10, 20, 30) selbst einen Wellenwiderstand von 86,66 Ω besaßen. Am Summationsein-oder -ausgang (99) betrug der Wellenwiderstand 50 Ω.

Mit einer Kapazität von 10 pF im Reihenschwingkreis (97, 98) und jeweils 2.2 pF in den drei Parallelschwingkreisen (11, 12; 21, 22; 31, 32), einem ohmschen Widerstand (130, 230, 330) von je 50 Ω in Reihe mit einer Kapazität (134, 234, 334) von je 3.9 pF und parallel zu einer weiteren Kapazität (132, 232, 332) von je 2.7 pF in den drei komplexen Lastausgleichswiderständen (13, 23, 33) sowie empirisch angepaßten Werten für die Länge der koaxialen Leitungen (12, 22, 32; 14; 24, 34) im Reihenschwingkreis und ind en drei Lastausgleichswiderständen wurde für dieses Labormuster im Frequenzbereich von etwa 470 MHz bis 860 MHz eine Entkopplung der parallelgeschalteten Ein-oder Ausgänge (19, 29, 39) großer 20 dB erzielt.

Es versteht sich, daß die hier vorgestellten Ausführungsbeispiele im Rahmen der Erfindung in vielerlei Weise abgeändert werden können. So können z. B. je nach elektrischer Kabellänge der koaxialen Leitungen (14, 24, 34) und (12, 22, 32) die komplexen Lastausgleichswiderstände (13, 23, 33) anders gestaltet werden, um je nach Anwendungsfall die elektrische Wirksamkeit der Lastausgleichswiderstände in der Brücke zu gewährleisten. Weiterhin können beispielsweise anstelle der Streifenleitungen (10, 20, 30) normale homogene Leitungen mit zylindrischem Querschnitt eingesetzt werden, die ebenfalls bei der Mittenfrequenz eine Länge von etwa 1/4 haben. Außerdem können anstelle einer bei etwa der Mittenfrequenz 1/4-langen Leitung auch mehrere in Kette geschaltete und bei etwa der Mittenfrequenz 1/4-langen Leitungs-oder Streifenleitungsstücke eingesetzt werden. Schließlich ist der Einsatz inhomogener Leitungen denkbar.

Mit der erfindungsgemäßen Lösung der Aufgabe können nicht nur Zweier-oder Dreierbrücken realisiert werden, sondern allgemein eine beliebige Zahl von Ein-oder Ausgängen (19, 29, 39...) rückwirdkungsarm parallelgeschaltet werden. Auch erstreckt sich das Anwendungsgebiet der Erfindung nicht nur auf die Sendertechnik, sondern kann in vielen anderen Gebieten, wie z. B. in Hochfrequenz-Schaltnetzteilen usw., eingesetzt werden.

## Ansprüche

1. Brückenschaltung mit Lastausgleichswiderständen (13, 23, 33) zum rückwirkungsarmen Parallelschalten von mindestens zwei Ein-oder Ausgängen (19, 29, 39) für Signale gleicher oder verschiedener Leistung oder Frequenz, bestehend aus mindestens zwei bei etwa der Mittenfrequenz 1/4-langen Leitungen (10, 20, 30), deren eine Enden in einem Summationspunkt (9) parallelgeschaltet sind und deren andere Enden voneinander getrennt jeweils an einen Verbindungspunkt (1, 2, 3) angeschlossen sind, an den auch jeweils einer der parallel zu schaltenden Ein-oder Ausgänge mit einem Pol angeschlossen ist, dadurch gekennzeichnet, daß die Leitungen (10, 20, 30) kompensiert und daß die Lastausgleichswiderstände (13, 23, 33) komplex und einseitig an Masse angeschlossen sind.

2. Brückenschaltung nach Anspruch 1, dadurch gekennzeichnet, daß zur Kompensation der Leitungen (10, 20, 30) an den Verbindungspunkten (1,2,3) jeweils ein Parallelschwingkreis mit Resonanzfrequenz etwa in Bandmitte angeordnet ist, der einseitig an Masse angeschlossen ist.

3. Brückenschaltung nach Anspruch 2, dadurch gekennzeichnet, daß ein solcher Parallelschwingkreis jeweils aus einem zwischen dem jeweiligen Verbindungspunkt (1, 2, 3) und Masse befindlichen Kondensator (11, 21, 31) und der Induktivität einer koaxialen Leitung (12, 22, 32) besteht, deren Länge in Abhängigkeit von der Kapazität des Kondensators so bemessen ist, daß die Resonanzfrequenz des Parallelschwingkreises etwa in Bandmitte liegt, deren Außenleiter (121, 221, 321) mit dem einen Ende an den jeweiligen Verbindungspunkt (1, 2, 3) und mit dem anderen Ende an Masse angeschlossen ist und deren Innenleiter (122, 222, 322) mit dem auf der Seite des Verbindungspunktes befindlichen Ende an die entsprechenden Enden der Innenleiter (122, 222, 322) der übrigen koaxialen Leitungen (12, 22, 32) und mit dem anderen Ende an den hochliegenden Anschluß des jeweiligen Lastausgleichswiderstandes angeschlossen ist.

4. Brückenschaltung nach einem der Ansprüche 1 bis 3, dadurch gekennzeichnet, daß zur Kompensation der Leitungen (10, 20, 30) am Summationspunkt (9) ein Reihenschwingkreis (97, 98) mit Resonanzfrequenz etwa in Bandmitte (97, 98) mit den Leitungen in Reihe geschaltet ist.

5. Brückenschaltung nach einem der Ansprüche 1 bis 4, dadurch gekennzeichnet, daß die Lastausgleichswiderstände (13, 23) im Falle einer Zweierbrücke jeweils aus einer Parallelschaltung aus einem ohmschen Widerstand (130) und einer Induktivität (131) besteht, wobei die Parallelschaltung mit dem einen Anschluß an Masse und mit dem anderen Anschluß an den Innenleiter (122, 222) der jeweiligen koaxialen Leitung (12, 22) angeschlossen ist.

6. Brückenschaltung nach Anspruch 5, dadurch gekennzeichnet, daß der Parallelschaltung (130, 131) ein Kondensator (132) parallelgeschaltet ist.

7. Brückenschaltung nach einem der Ansprüche 1 bis 4, dadurch gekennzeichnet, daß die Lastausgleichswiderstände (13, 23, 33) im Falle einer Dreierbrücke jeweils aus einer Parallelschaltung aus einer Induktivität (131), einem Kondensator (132) und einer Reihenschaltung, bestehend aus einer weiteren Induktivität (133), einem weiteren Kondensator (134) und einem ohmschen Widerstand (130), besteht, wobei die Parallelschaltung mit dem einen Anschluß an Masse und mit dem anderen Anschluß an den Innenleiter (122, 222, 322) der jeweiligen koaxialen Leitung (12, 22, 32) angeschlossen ist.

8. Brückenschaltung nach einem der Ansprüche 1 bis 7, dadurch gekennzeichnet, daß zur richtigen Transformation der Lastausgleichswiderstände (13, 23, 33) and die Brückenschaltund jeweils zwischen dem nicht masseseitigen Anschluß des jeweiligen Lastausgleichswiderstands und dem Innenleiter (122, 222, 322) der koaxialen Leitung (12, 22, 32) des jeweiligen Parallelschwingkreises der Innenleiter (142, 242, 342) einer weiteren koaxialen Leitung (14, 24, 34) angeschlossen ist, deren Außenleiter (141, 241, 341) an beiden Enden an Masse angeschlossen ist.

9. Brückenschaltung nach einem der Ansprüche 1 bis 8, dadurch gekennzeichnet, daß die kompensierten Leitungen (10, 20, 30) und/oder die Leitungen (18, 28, 38) von den Verbindungspunkten (1, 2, 3) zu den Ein-oder Ausgängen (19, 29, 39) als Streifenleitungen ausgeführt sind.

10. Brückenschaltung nach einem der Ansprüche 1 bis 9, dadurch gekennzeichnet, daß die komensierten Leitungen (10, 20, 30) jeweils aus mindestens zwei in Kette geschalteten und bei etwa der Mittenfrequenz 1/4-langen Leitungsstücken bestehen.

FIG. 2

FIG. 1

FIG. 4

FIG. 3